# EUROPEAN PATENT APPLICATION

(11) **EP 4 788 065 A1**
(43) Date of publication of application: **05.08.2026**
(21) Application number: 24870538.6
(22) Date of filing: 19.09.2024
(51) Int. Cl.: H05K 1/02, H05K 1/18, B60R 16/02, H05K 7/10

(54) **CONTROLLER AND VEHICLE**

(30) Priority: 28.09.2023 CN 202322671833 U
(71) Applicant: BYD Company Limited, Shenzhen, Guangdong 518118 (CN)
(72) Inventor: LV, Shujun, Shenzhen, Guangdong 518118 (CN); YANG, Ke, Shenzhen, Guangdong 518118 (CN); ZHAO, Xi, Shenzhen, Guangdong 518118 (CN); ZHANG, Ruiting, Shenzhen, Guangdong 518118 (CN); WANG, Lei, Shenzhen, Guangdong 518118 (CN)
(74) Representative: Taor, Simon Edward William
(86) International application number: PCT/CN2024/119556
(87) International publication number: WO 2025/066994

(57) **Abstract**

A controller and a vehicle. The controller comprises a first housing, a second housing, and a circuit board assembly. The first housing has a first insertion slot extending through the thickness of the first housing. The second housing is connected to the first housing. The second housing and the first housing jointly define a mounting cavity. The second housing has a second insertion slot extending through the thickness of the second housing. The first insertion slot and the second insertion slot are in communication with the mounting cavity. The circuit board assembly is disposed in the mounting cavity. The circuit board assembly comprises a circuit board, a first insertion connector, and a second insertion connector. At least part of the first insertion connector extends out of the first housing from the first insertion slot. At least part of the second insertion connector extends out of the second housing from the second insertion slot.

## Description

### CROSS-REFERENCE TO RELATED APPLICATIONS

The present application claims priority to the Chinese patent application filed with the China Patent Office on September 28, 2023, with application number 202322671833.8 and application name "CONTROLLER AND VEHICLE", the entire content of which is incorporated herein by reference.

### FIELD

This application relates to the field of controller technology, specifically to a controller and a vehicle.

### BACKGROUND

Controller is a type of circuit integrated device, whose main function is to integrate the application software functions of one or more functional domains of the vehicle into one controller, facilitating collaborative control, avoiding a large amount of information exchange through the bus, and accelerating software response.

When wiring existing controllers, it is necessary to first lead the harness out of the controller's port, then transfer the harness to the target electrical wiring area through connectors, and finally complete the electrical connection with the target electrical in the wiring area. Wiring in this way requires a long harness length and a large number of connectors, resulting in high wiring costs.

### SUMMARY

The present disclosure provides a controller and a vehicle, which aim to solve the problem of high wiring cost in existing controller structures.

To solve the aforementioned technical issues, in the first aspect, the present disclosure provides a controller. The controller includes:
a first housing, the first housing having a first insertion slot extending through the thickness of the first housing;
a second housing, the second housing being connected to the first housing, the second housing and the first housing jointly defining a mounting cavity, the second housing having a second insertion slot extending through the thickness of the second housing, and the first insertion slot and the second insertion slot being in communication with the mounting cavity; and
a circuit board assembly, the circuit board assembly being disposed in the mounting cavity, the circuit board assembly including a circuit board, a first insertion connector, and a second insertion connector, the first insertion connector and the second insertion connector being respectively arranged on opposite sides of the circuit board, at least part of the first insertion connector extending out of the first housing from the first insertion slot, and at least part of the second insertion connector extending out of the second housing from the second insertion slot.

In one possible embodiment, the first insertion connector is configured to electrically connect to a device connected to a cabin area of a vehicle equipped with the controller, and the second insertion connector is configured to electrically connect to a device in a chassis area of the vehicle.

In one possible embodiment, the first insertion connector includes at least one of a door harness port and an dashboard harness port, the door harness port is configured to electrically connect to a door device of the vehicle, and the dashboard harness port is configured to electrically connect to a dashboard device of the vehicle; and
the second insertion connector includes at least one of a chassis harness port and a front protection device port, the chassis harness port is configured to electrically connect to a chassis device of the vehicle, and the front protection device port is configured to electrically connect to a front protection device of the vehicle.

In one possible embodiment, the second housing has a first through hole, the circuit board has a second through hole, and the first housing has a third through hole; and
the controller further includes a power input component, the power input component passing through the first through hole, the second through hole, and the third through hole in sequence.

In one possible embodiment, the first end of the power input component extends out of the surface of the second housing facing away from the first housing, and is configured to be connected to a power terminal.

In one possible embodiment, the power input component is integrally formed with the second housing.

In one possible embodiment, the controller further includes a power distribution output component arranged on a side of the first housing facing away from the second housing; and
the second end of the power input component extends out of the surface of the first housing facing away from the second housing, and is electrically connected to the power distribution output component.

In one possible embodiment, the controller further includes a safety component, the safety component includes a main body, a first connecting portion, and a second connecting portion, the first connecting portion and the second connecting portion is respectively arranged on opposite sides of the main body, the first connecting portion has a first connecting hole, and the second connecting portion has a second connecting hole; and
the power input component is inserted through the first connecting hole, and the power distribution output component is inserted through the second connecting hole.

In one possible embodiment, the controller further includes a power interface component connected the power distribution output component and the circuit board.

In one possible embodiment, the first housing has a through slot;
the power interface component includes a first connecting component and a second connecting component;
the first connecting component includes a main body plate and a connecting plate; one end of the connecting plate is connected to the main body plate, the other end of the connecting plate extends in a direction away from the main body plate, a side of the connecting plate away from the main body plate has a slot, the connecting plate extends from the through slot into a mounting hole, and the main body plate is connected to the power distribution output component; and
one end of the second connecting component extends into the slot, and the other end of the second connecting component is connected to the circuit board.

In the second aspect, the present disclosure provides a vehicle. The vehicle includes a controller;
the controller includes:
a first housing, the first housing having a first insertion slot extending through the thickness of the first housing;
a second housing, the second housing being connected to the first housing, the second housing and the first housing jointly defining a mounting cavity, the second housing having a second insertion slot extending through the thickness of the second housing, and the first insertion slot and the second insertion slot being in communication with the mounting cavity; and
a circuit board assembly, the circuit board assembly being disposed in the mounting cavity, the circuit board assembly comprising a circuit board, a first insertion connector, and a second insertion connector, the first insertion connector and the second insertion connector being respectively arranged on opposite sides of the circuit board, at least part of the first insertion connector extending out of the first housing from the first insertion slot, and at least part of the second insertion connector extending out of the second housing from the second insertion slot; and
the vehicle has a first functional area and a second functional area; the first housing of the controller is arranged corresponding to the first functional area, and the second housing of the controller is arranged corresponding to the second functional area; the first insertion connector of the controller is electrically connected to a device in the first functional area, and the second insertion connector of the controller is electrically connected to a device in the second functional area.

In the disclosed technical solution, the controller includes a first housing and a second housing. The first housing is arranged corresponding to the first functional area of the vehicle, and the second housing is arranged corresponding to the second functional area of the vehicle. The first housing has a first insertion slot, and the second housing has a second insertion slot. The circuit board has a first insertion connector and a second insertion connector that are arranged opposite to the first housing and the second housing, respectively. The first insertion connector extends out of the first housing from the first insertion slot, and the second connector extends out of the second housing from the second insertion slot. When wiring the controller, the electrical device in the first functional area can be connected to the controller through the first insertion connector, and the electrical device in the second functional area can be connected to the controller through the second connector. In this way, nearby wiring of electrical device is achieved, reducing the length of the harness, minimizing the use of connectors, and lowering wiring costs.

In one possible embodiment, the first functional area is a cabin area, the second functional area is a chassis area; and
the first insertion connector is configured to electrically connect to a device in a cabin area, and the second insertion connector is configured to electrically connect to a device in a chassis area.

In one possible embodiment, the cabin area of the vehicle includes a door device and a dashboard device, the first insertion connector includes at least one of a door harness port and an dashboard harness port, the door harness port is configured to electrically connect to a door device, and the dashboard harness port is configured to electrically connect to a dashboard device; and
the chassis area of the vehicle includes a chassis device and a front protection device, the second insertion connector includes at least one of a chassis harness port and a front protection device port, the chassis harness port is configured to electrically connect to a chassis device, and the front protection device port is configured to electrically connect to a front protection device.

In one possible embodiment, the second housing has a first through hole, the circuit board has a second through hole, and the first housing has a third through hole; and
the controller further includes a power input component, the power input component passing through the first through hole, the second through hole, and the third through hole in sequence.

In one possible embodiment, the first end of the power input component extends out of the surface of the second housing facing away from the first housing, and is configured to be connected to a power terminal.

In one possible embodiment, the power input component is integrally formed with the second housing.

In one possible embodiment, the controller further includes a power distribution output component arranged on a side of the first housing facing away from the second housing; and
the second end of the power input component extends out of the surface of the first housing facing away from the second housing, and is electrically connected to the power distribution output component.

In one possible embodiment, the controller further includes a safety component, the safety component includes a main body, a first connecting portion, and a second connecting portion, the first connecting portion and the second connecting portion is respectively arranged on opposite sides of the main body, the first connecting portion has a first connecting hole, and the second connecting portion has a second connecting hole; and
the power input component is inserted through the first connecting hole, and the power distribution output component is inserted through the second connecting hole.

In one possible embodiment, the controller further includes a power interface component connected the power distribution output component and the circuit board.

In one possible embodiment, the first housing has a through slot;
the power interface component includes a first connecting component and a second connecting component which are connected to each other;
the first connecting component includes a main body plate and a connecting plate; one end of the connecting plate is connected to the main body plate, the other end of the connecting plate extends in a direction away from the main body plate, a side of the connecting plate away from the main body plate has a slot, the connecting plate extends from the through slot into a mounting hole, and the main body plate is connected to the power distribution output component; and
one end of the second connecting component extends into the slot, and the other end of the second connecting component is connected to the circuit board.

### BRIEF DESCRIPTION OF THE DRAWINGS

To more clearly illustrate the technical solutions in the embodiments of the present disclosure or the prior art, the accompanying drawings required for the description of the embodiments or the prior art will be briefly introduced below. It is apparent that the drawings described below are merely some embodiments of the present invention, and for person having ordinary skill in the art, other drawings can be obtained based on these drawings without creative effort.
FIG. 1 is an exploded view of a controller according to an embodiment of the present disclosure.
FIG. 2 is a structural schematic view of the first housing in FIG. 1.
FIG. 3 is a structural schematic view of the second housing in FIG. 1.
FIG. 4 is a structural schematic view of the circuit board assembly in FIG. 1.
FIG. 5 is a structural schematic view of the controller viewed from the perspective of the second housing according to the present disclosure.
FIG. 6 is a structural schematic view of the controller viewed from the perspective of the first housing according to the present disclosure.
FIG. 7 is a structural schematic view of the safety member in FIG. 1.
FIG. 8 is a structural schematic view of the structure after removing the first housing and the power distribution output component from FIG. 6.
FIG. 9 is a structural schematic view of the power interface component in FIG. 1.
FIG. 10 is a structural schematic view of a vehicle according to the present disclosure.

Reference numerals:
1000, controller; 1, first housing; 11, third through hole; 12, first insertion slot; 13, through slot; 14,snap-fit; 2, second housing; 21, first through hole; 22, second insertion slot; 23, snap-fit slot; 24, mounting cavity; 3, circuit board assembly; 31, circuit board; 311, second through hole; 32, first insertion connector; 33, second insertion connector; 4, power input component; 5, power distribution output component; 6, safety member; 61, main body; 62, first connecting portion; 621, first connecting hole; 63, second connecting portion; 631, second connecting hole; 7, power interface component; 71, first connecting component; 711, main body plate; 712, connecting plate; 713, slot; 714, power distribution hole; 72, second connecting component; 2000, vehicle.

### DETAILED DESCRIPTION

Below, the technical solutions in the embodiments of the present disclosure will be clearly and comprehensively described with reference to the accompanying drawings. Obviously, the described embodiments are merely a part of the embodiments of the present invention, not all of them. Based on the embodiments of the present invention, all other embodiments obtained by person having ordinary skill in the art without creative effort fall within the scope of protection of the present invention.

It should be noted that when a component is referred to as "fixed to" another component, it can be directly attached to the other component or there may be a component in between. When a component is considered to be "connected to" another component, it can be directly connected to the other component or there may be a component in between.

Unless otherwise defined, all technical and scientific terms used in this disclosure have the same meaning as commonly understood by person having ordinary skill in the art to which this invention belongs. The terms used in the specification of this invention are solely for the purpose of describing specific embodiments and are not intended to limit the invention. The term "and/or" used in this invention includes any and all combinations of one or more related listed items.

Below, some embodiments of the present disclosure will be described in detail with reference to the accompanying drawings. The embodiments described below and the features thereof may be combined with each other without conflict.

When wiring existing controllers, it is necessary to first lead the harness out of the controller's port, then transfer the harness to the target electrical wiring area through connectors, and finally complete the electrical connection with the target electrical in the wiring area. Wiring in this way requires a long harness length and a large number of connectors, resulting in high wiring costs.

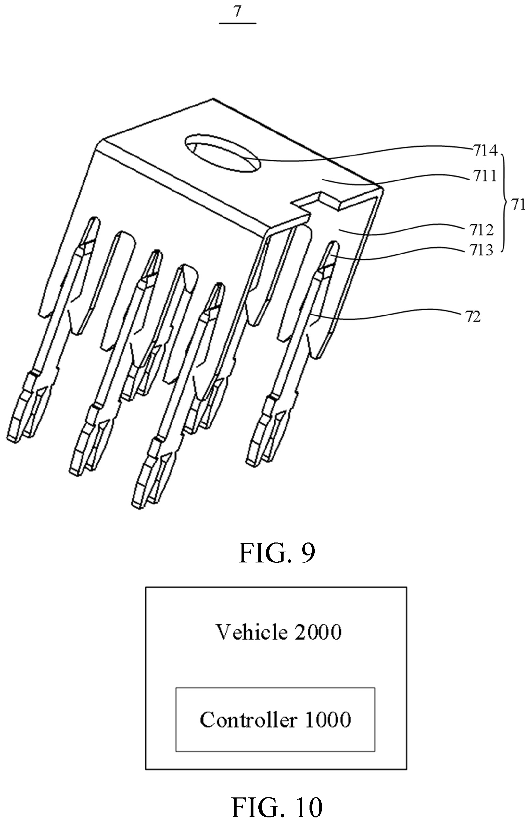

To solve the aforementioned technical issues, this disclosure provides a vehicle. The vehicle can be a car, a truck, a motorcycle, or any other type of vehicle, and this disclosure does not limit it. The vehicle 2000 has a first functional area (not shown) and a second functional area (not shown). As shown in FIG. 10, the vehicle 2000 also includes a controller 1000, which is used to integrate the electrical devices of the first functional area and the second functional area.

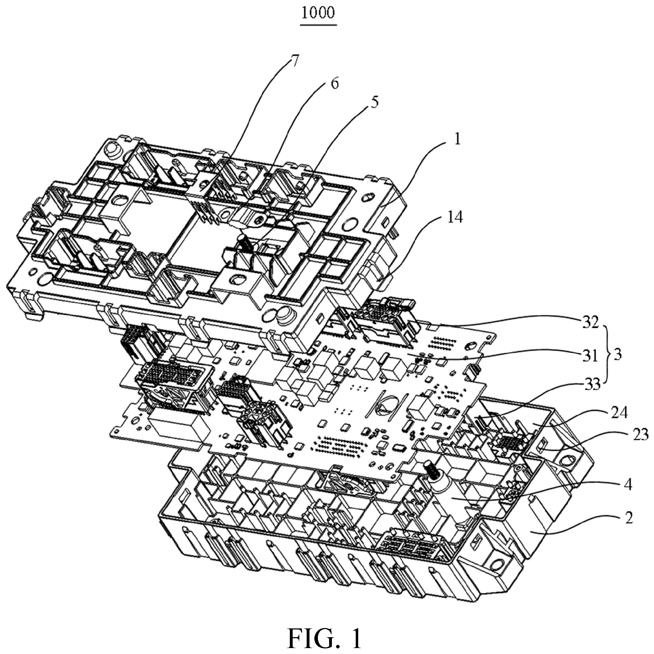

Referring to FIG. 1 to FIG. 3, the controller 1000 includes a first housing 1, a second housing 2, and a circuit board assembly 3. The first housing 1 has a first insertion slot 12 extending through its thickness. The second housing 2 has a second insertion slot 22 extending through its thickness. The second housing 2 and the first housing 1 are interconnected and jointly define a mounting cavity 24. The first insertion slot 12 and the second insertion slot 22 are in communication with the mounting cavity 24.

The first housing 1 and the second housing 2 can be connected through magnetic attraction, threaded connection, or snap-fit connection using snap-fits 14. This disclosure does not limit the connection method. To facilitate assembly and disassembly, in one embodiment of this disclosure, the first housing 1 has snap-fits 14, and the second housing 2 has snap-fit slots 23. When assembling the first housing 1 and the second housing 2, simply engage the snap-fits 14 of the first housing 1 into the snap-fit slots 23 of the second housing 2 to complete the fixed installation of the first housing 1 and the second housing 2. This is convenient and quick, improving assembly efficiency.

The circuit board assembly 3 is disposed in the mounting cavity 24. The circuit board assembly 3 includes a circuit board 31, a first insertion connector 32, and a second insertion connector 33, The first insertion connector 32 and the second insertion connector 33 are respectively arranged on opposite sides of the circuit board 31. At least part of the first insertion connector 32 extends out of the first housing 1 from the first insertion slot 12. At least part of the second insertion connector 33 extends out of the second housing 2 from the second insertion slot 22.

In the disclosed technical solution, the controller 1000 includes a first housing 1 and a second housing 2. The first housing 1 is arranged corresponding to the first functional area of the vehicle, and the second housing 2 is arranged corresponding to the second functional area of the vehicle. The first housing 1 has a first insertion slot 12, and the second housing 2 has a second insertion slot 22. The circuit board 31 has a first insertion connector 32 and a second insertion connector 33 that are arranged opposite to the first housing 1 and the second housing 2, respectively. The first insertion connector 32 extends out of the first housing 1 from the first insertion slot 12, and the second connector 33 extends out of the second housing 2 from the second insertion slot 22. When wiring the controller 1000, the electrical device in the first functional area can be connected to the controller through the first insertion connector 32, and the electrical device in the second functional area can be connected to the controller 1000 through the second connector 33. In this way, nearby wiring of electrical device is achieved, reducing the length of the harness, minimizing the use of connectors, and lowering wiring costs.

It can be understood that there are various criteria for dividing the first functional area and the second functional area mentioned above. For example, when dividing areas based on vehicle device functions, the first functional area and the second functional area can be divided into door mechanism area, seat mechanism area, brake function area, oil circuit function area, etc.

For example, when dividing areas based on vehicle space, the first functional area and the second functional area can be divided into the cabin area and the chassis area. In the cabin area, the vehicle includes door device and dashboard device. The door device includes electrical devices such as the vehicle's window lifting mechanism, door lock control mechanism, turn signal mechanism, and controller 1000 mechanism. The dashboard device includes electrical devices such as the vehicle's instrument distribution box, indoor lights, seats, air conditioning box, wiper motor, accelerator and brake pedals, EPB switch, etc. For the chassis area, vehicle includes chassis device and front protection device. The chassis device includes electrical devices such as radar probes, three-way water valves, PT pressure sensors, electronic expansion valves, solenoid valves, throttle and brake signal calibration feet, etc. The front protection device includes electrical devices such as combination lights, fog lights, washing motors, etc.

In one embodiment of this disclosure, the first functional area is a cabin area, and the second functional area is a chassis area. In the cabin area, the first insertion connector 32 has a door harness port and a dashboard harness port. The door harness port is configured to electrically connect to a door device in a cabin area, and the dashboard harness port is configured to electrically connect to a dashboard device in a cabin area. It can be understood that in this embodiment, the door harness port and the dashboard harness port can be located on the same first insertion connector 32 or on different first insertion connectors 32, and this disclosure does not limit this. In some embodiments, only the door harness port can be set on the first insertion connector 32, without setting the dashboard harness port; in some embodiments, only the dashboard harness port can be set on the first insertion connector 32, without setting the door harness port, and this disclosure also does not limit this.

In the chassis area, the second insertion connector 33 has a chassis harness port and a front protection device port. The chassis harness port is configured to electrically connect to a chassis device, and the front protection device port is configured to electrically connect to a front protection device. It can be understood that in this embodiment, the chassis harness port and the front protection device port can be located on the same first insertion connector 32 or on different first insertion connectors 32, and this disclosure does not limit this. In some embodiments, only the chassis harness port can be set on the second insertion connector 33, without setting the front protection device port; in some embodiments, only the front protection device port can be set on the second insertion connector 33, without setting the chassis harness port, and this disclosure also does not limit this.

It can be understood that in other embodiments of this disclosure, the first functional area is a chassis area, and the second functional area is a cabin area. Correspondingly, in the chassis area, the first insertion connector 32 has a chassis harness port and a front protection device port, in the cabin area, the second insertion connector 33 has a door harness port and a dashboard harness port, this disclosure does not limit this.

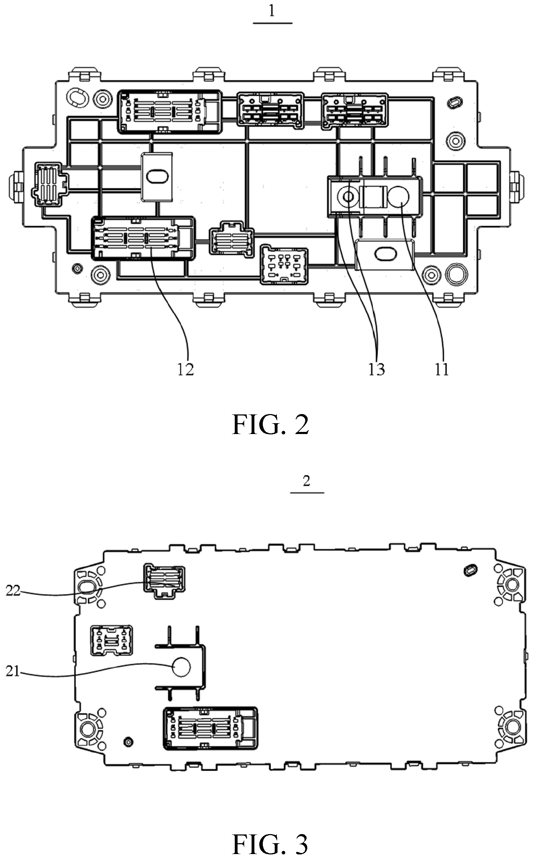

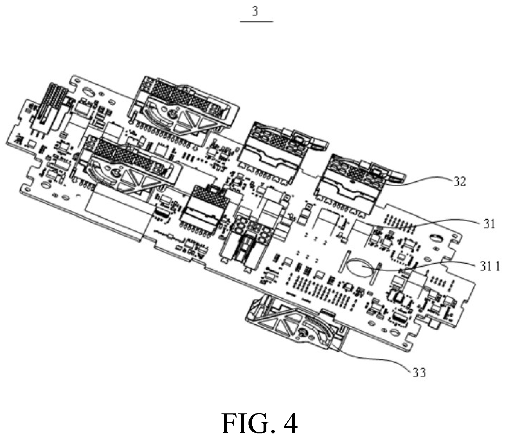

Referring to FIG. 3, FIG. 4, and FIG. 5, the controller 1000 further includes a power input terminal, and the power input terminal is configured to provide stable power for the controller 1000 and the entire vehicle. Specifically, in one embodiment of this disclosure, the second housing 2 has a first through hole 21, the circuit board 31 has a second through hole 311, and the first housing 1 has a third through hole 11; the power input terminal includes a power input component 4 and a power terminal (not shown), and the power input component 4 passes through the first through hole 21, the second through hole 311, and the third through hole 11 in sequence to inserted through the first housing 1 and the second housing 2; the first end of the power input component 4 extends out of the surface of the second housing 2 facing away from the first housing 1 and is connected to the power terminal. The power terminal is connected to the power supply and provides a stable 12V power supply to the entire controller 1000 and electrical device connected to the controller 1000 through the power input component 4.

The power input component 4 can be a conductive rod or a conductive bolt, and this disclosure does not limit it. In one embodiment of this disclosure, the power input component 4 uses conductive bolts, and the power terminals can be directly connected to the power input component 4 through threads, eliminating the need for other fasteners, reducing the difficulty of component assembly, and improving assembly efficiency.

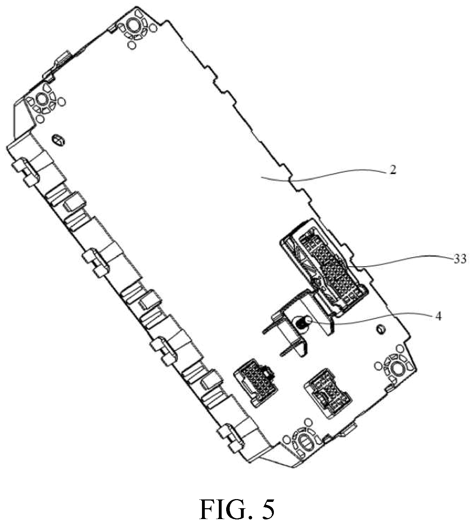

To reduce the impact of the power terminal on the circuit board 31, referring to FIG. 5, in one embodiment of this disclosure, at least part of the power input component 4 is fixed to the first housing 1 or the second housing 2, or both are fixed to the first housing 1 and the second housing 2. Thus, when the power terminals or other components are installed into the power input component 4, the assembly torque of the components can be fully borne by the first casing 1 or the second casing 2, and the power input part 4. This prevents the torque from being transmitted to the circuit board 31, thereby ensuring the protection of the circuit board 31.

There are various ways to fix the power input component 4 to the first housing 1 or the second housing 2. The first input component can be fixed to the first housing 1 or the second housing 2 by adhesive, or can be hot-melt to the first housing 1 and the second housing 2. This disclosure does not limit this. In order to improve the stability of the connection between the power input component 4 and the first housing 1 or the second housing 2, in one embodiment of this disclosure, the power input component 4 is integrally formed by injection molding within the first through hole 21 of the second housing 2. In this way, while ensuring a stable connection between the power input component 4 and the second housing 2, the installation of the power input component 4 during the assembly process can be simplified, thereby improving assembly efficiency.

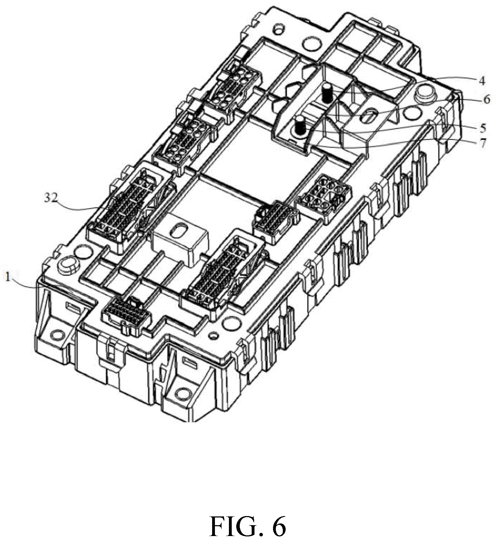

Referring to FIG. 1 and FIG. 6, the controller 1000 further includes a power distribution output component 5, the power distribution output component 5 is connected to the power input component 4 and can output the current input from the power input component 4 to achieve external distribution. The power distribution output component 5 and the power input component 4 can be located on the same side or on different sides, and this disclosure does not limit this. In one embodiment of this disclosure, the power distribution output component 5 is arranged on a side of the first housing facing away from the second housing, and the second end of the power input component 4 extends out of the surface of the first housing 1 facing away from the second housing 2 and is electrically connected to the power distribution output component 5. In this way, the power input and output of controller 1000 can be separated on both sides of controller 1000, which can avoid overcrowding of wiring on one side of controller 1000, optimize the wiring structure of controller 1000, reduce the difficulty of wiring for controller 1000, and lower wiring costs.

The power input component 4 and the power distribution output component 5 can be arranged in parallel or vertically, and this disclosure does not limit this. In one embodiment of this disclosure, the power input component 4 and the power distribution output component 5 are arranged in parallel along the thickness direction of the first housing 1 and the second housing 2. This can reduce the occupation of the planar space of the controller 1000 by the power input component 4 and the power distribution output component 5, thereby reducing the occupation of the vehicle space by the entire controller 1000 and facilitating the installation of the controller 1000.

The power distribution output component 5 can be a conductive rod or a conductive bolt, and this disclosure does not limit it. In one embodiment of this disclosure, the power distribution output component 5 is a conductive bolt. In this way, other components of controller 1000 can be directly screwed onto the power distribution output component 5 without the need for other fasteners, thereby reducing the difficulty of component assembly and improving assembly efficiency.

Referring to FIG. 6, a safety component 6 is arranged between the power input component 4 and the power distribution output component 5. The power input component 4 and the power distribution output component 5 are electrically connected through the safety component 6. The setting of safety component 6 can cut off the circuit between the power input component 4 and the power distribution output component 5 when there is a fault or abnormality in the circuit between them resulting in an abnormal increase in current. This provides protection for the controller 1000 and other electrical appliances, ensuring the safety of the vehicle while supplying power to other electrical appliances, and avoiding excessive current from burning the circuit or even causing a fire.

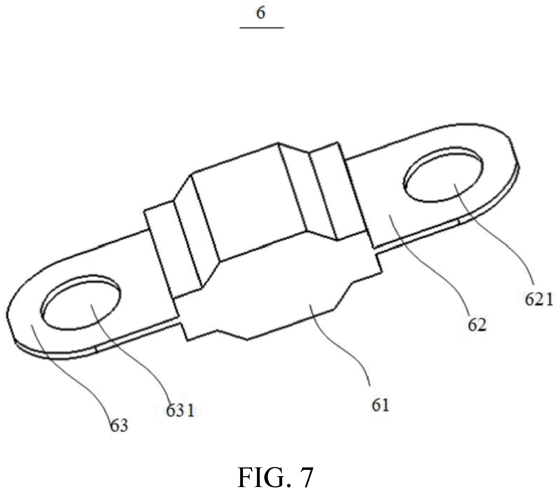

The safety component 6 can be a fuse or other safety device, and this disclosure does not limit this. Referring to FIG. 7, in one embodiment of this disclosure, the safety component 6 includes a main body 61, a first connecting portion 62, and a second connecting portion 63. The first connecting portion 62 and the second connecting portion 63 are respectively arranged on opposite sides of the main body 61. The first connecting portion 62 has a first connecting hole 621, and the second connecting portion 63 has a second connecting hole 631. The power input component 4 is inserted through the first connecting hole 621, and the power distribution output component 5 is inserted through the second connecting hole 631. The current can be transmitted from the power input component 4 to the first connection portion 62, through the first connection portion 62 to the main body 61, through the main body 61 to the second connecting portion 63, and finally through the second connecting portion 63 to the power distribution output component 5. In this way, while ensuring the transmission of current from the power input component 4 to the power distribution output component 5, the safety component 6 can also be vertically arranged with both the power input component 4 and the power distribution output component 5. This can reduce the occupation of space by the power input component 4, the power distribution output component 5, and the safety component 6 on the first housing 1, facilitate the arrangement of other structural components on the first housing 1, and thus make reasonable use of the space of the first housing 1.

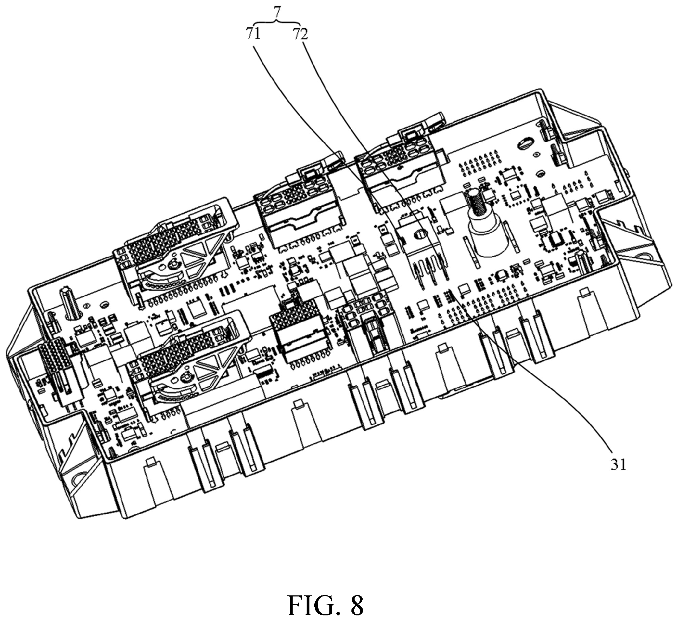

Referring to FIG. 1, FIG. 2, FIG. 6, and FIG. 8, in one embodiment of this disclosure, the controller 1000 further includes a power interface component 7 connected the power distribution output component 5 and the circuit board 31. After the current flows into the power distribution output component 5, a portion of the current will be transmitted to other electrical equipment of the vehicle through the power distribution output component 5, while another portion of the current will flow to the circuit board 31 through the power interface component 7 to supply power to the circuit board 31.

There can be various forms of power interface component 7. The power interface component 7 can be a copper bar or a tuning fork copper sheet, and this disclosure does not limit it. In one embodiment of this disclosure, the power interface component 7 includes a first connecting component 71 and a second connecting component 72 which are connected to each other. The first connecting component 71 is configured to connect with the power distribution output component 5, and the second connecting component 72 is configured to transmit current from the first connecting component 71 to the circuit board 31.

Referring to FIG. 9, the first connecting component 71 includes a main body plate 711 and a connecting plate 712. The main board 711 has power distribution hole 714, and the power distribution hole 714 is sleeved over the power distribution output component 5 and fixedly connected to it. In this way, the first connecting component 71 can be electrically connected to the power distribution output component 5. There are various ways to fix the main body plate 711 to the power distribution output component 5. The main body plate 711 can be electrically connected to the power distribution output component 5 through a threaded structure, or directly welded to the power distribution output component 5. This disclosure does not limit this. One end of the connecting plate 712 is connected to the main body plate 711, and the other end of the connecting plate 712 extends into the through slot 13 of the first housing 1 in a direction away from the main body plate 711 to connect with the second connecting component 72.

One end of the second connecting component 72 is connected to the connecting plate 712, and the other end of the second connecting component 72 is connected to the circuit board 31, thereby achieving electrical connection between the power distribution output piece 5 and the circuit board 31. It can be understood that there are various ways to connect the second connecting component 72 to the circuit board 31. The connecting component 72 can be bonded to the circuit board 31 through conductive adhesive, or electrically connected to the circuit board 31 through welding. This disclosure does not limit this.

It can be understood that when the power interface component 7 is connected to the power distribution output component 5 through a threaded structure, the torque of the threaded structure will be transmitted downward through the first connecting component 71, and ultimately reach the circuit board 31 through the second connecting component 72, causing damage to the circuit board 31. To solve the above problems, in this embodiment, a side of the connecting plate 712 away from the main body plate 711 also has a slot 713, and the second connecting component 72 extends into the slot 713 to connect with the first connecting component 71. The second connecting component 72 and the connecting plate 712 are matched through the slot gap. In this way, the transmission of force from the first connector 71 to the second connector 72 can be reduced, thereby reducing the thread torque reaching the circuit board 31 and reducing the possibility of damage to the circuit board 31.

In the description of the embodiments of the present invention, it should be noted that the orientation or positional relationship of the terms "center", "up", "down", "left", "right", "vertical", "horizontal", "inside", "outside" and other indicators is based on the orientation or positional relationship described in the accompanying drawings, only for the convenience of describing the present invention and simplifying the description, and does not indicate or imply that the device or element referred to must have a specific orientation, be constructed and operated in a specific orientation, and therefore cannot be understood as a limitation of the present invention.

The above disclosure is only a preferred embodiment of the present invention and cannot be used to limit the scope of the present invention. Person having ordinary skill in the art can understand and implement all or part of the above embodiments, and any equivalent variations made according to the claims of this invention still fall within the scope of this invention.

## Claims

1. A controller (1000), comprising:
a first housing (1), the first housing having a first insertion slot (12) extending through the thickness of the first housing;
a second housing (2), the second housing being connected to the first housing, the second housing and the first housing jointly defining a mounting cavity (24), the second housing having a second insertion slot (22) extending through the thickness of the second housing, and the first insertion slot and the second insertion slot being in communication with the mounting cavity; and
a circuit board assembly (3), the circuit board assembly being disposed in the mounting cavity, the circuit board assembly comprising a circuit board (31), a first insertion connector (32), and a second insertion connector (33), the first insertion connector and the second insertion connector being respectively arranged on opposite sides of the circuit board, at least part of the first insertion connector extending out of the first housing from the first insertion slot, and at least part of the second insertion connector extending out of the second housing from the second insertion slot.

2. The controller according to claim 1, wherein
the first insertion connector is configured to electrically connect to a device in a cabin area of a vehicle (2000) equipped with the controller, and the second insertion connector is configured to electrically connect to a device in a chassis area of the vehicle.

3. The controller according to claim 2, wherein
the first insertion connector comprises at least one of a door harness port and an dashboard harness port, the door harness port being configured to electrically connect to a door device of the vehicle, and the dashboard harness port being configured to electrically connect to a dashboard device of the vehicle; and
the second insertion connector comprises at least one of a chassis harness port and a front protection device port, the chassis harness port being configured to electrically connect to a chassis device of the vehicle, and the front protection device port being configured to electrically connect to a front protection device of the vehicle.

4. The controller according to any one of claims 1 to 3, wherein
the second housing has a first through hole (21), the circuit board has a second through hole (311), and the first housing has a third through hole (11); and
the controller further comprises a power input component (4), the power input component passing through the first through hole, the second through hole, and the third through hole in sequence.

5. The controller according to claim 4, wherein
the first end of the power input component extends out of the surface of the second housing facing away from the first housing, and is configured to be connected to a power terminal.

6. The controller according to claim 4, wherein
the power input component is integrally formed with the second housing.

7. The controller according to claim 5, wherein
the controller further comprises a power distribution output component (5) arranged on a side of the first housing facing away from the second housing; and
the second end of the power input component extends out of the surface of the first housing facing away from the second housing, and is electrically connected to the power distribution output component.

8. The controller according to claim 7, wherein
the controller further comprises a safety component (6), the safety component comprising a main body (61), a first connecting portion (62), and a second connecting portion (63), the first connecting portion and the second connecting portion being respectively arranged on opposite sides of the main body, the first connecting portion having a first connecting hole (621), and the second connecting portion having a second connecting hole (631); and
the power input component is inserted through the first connecting hole, and the power distribution output component is inserted through the second connecting hole.

9. The controller according to claim 7, wherein
the controller further comprises a power interface component (7) connected the power distribution output component and the circuit board.

10. The controller according to claim 9, wherein
the first housing has a through slot (13);
the power interface component comprises a first connecting component (71) and a second connecting component (72) which are connected to each other;
the first connecting component comprises a main body plate (711) and a connecting plate (712); one end of the connecting plate is connected to the main body plate, the other end of the connecting plate extends in a direction away from the main body plate, a side of the connecting plate away from the main body plate has a slot (713), the connecting plate extends from the through slot into a mounting hole, and the main body plate is connected to the power distribution output component; and
one end of the second connecting component extends into the slot, and the other end of the second connecting component is connected to the circuit board.

11. A vehicle (2000), comprising a controller (1000);
the controller comprising:
a first housing (1), the first housing having a first insertion slot (12) extending through the thickness of the first housing;
a second housing (2), the second housing being connected to the first housing, the second housing and the first housing jointly defining a mounting cavity (24), the second housing having a second insertion slot (22) extending through the thickness of the second housing, and the first insertion slot and the second insertion slot being in communication with the mounting cavity; and
a circuit board assembly (3), the circuit board assembly being disposed in the mounting cavity, the circuit board assembly comprising a circuit board (31), a first insertion connector (32), and a second insertion connector (33), the first insertion connector and the second insertion connector being respectively arranged on opposite sides of the circuit board, at least part of the first insertion connector extending out of the first housing from the first insertion slot, and at least part of the second insertion connector extending out of the second housing from the second insertion slot; and
the vehicle has a first functional area and a second functional area; the first housing of the controller is arranged corresponding to the first functional area, and the second housing of the controller is arranged corresponding to the second functional area; the first insertion connector of the controller is electrically connected to a device in the first functional area, and the second insertion connector of the controller is electrically connected to a device in the second functional area.

12. The vehicle according to claim 11, wherein
the first functional area is a cabin area, and the second functional area is a chassis area; and
the first insertion connector is configured to electrically connect to a device in a cabin area, and the second insertion connector is configured to electrically connect to a device in a chassis area.

13. The vehicle according to any one of claims 12, wherein
the cabin area of the vehicle comprises a door device and a dashboard device,
the first insertion connector comprises at least one of a door harness port and an dashboard harness port, the door harness port being configured to electrically connect to a door device, and the dashboard harness port being configured to electrically connect to a dashboard device; and
the chassis area of the vehicle comprises a chassis device and a front protection device, the second insertion connector comprises at least one of a chassis harness port and a front protection device port, the chassis harness port being configured to electrically connect to a chassis device, and the front protection device port being configured to electrically connect to a front protection device.

14. The vehicle according to any one of claims 11 to 13, wherein
the second housing has a first through hole (21), the circuit board has a second through hole (311), and the first housing has a third through hole (11); and
the controller further comprises a power input component (4), the power input component passing through the first through hole, the second through hole, and the third through hole in sequence.

15. The vehicle according to claim 14, wherein
the first end of the power input component extends out of the surface of the second housing facing away from the first housing, and is configured to be connected to a power terminal.

16. The vehicle according to claim 14, wherein
the power input component is integrally formed with the second housing.

17. The vehicle according to claim 15, wherein
the controller further comprises a power distribution output component (5) arranged on a side of the first housing facing away from the second housing; and
the second end of the power input component extends out of the surface of the first housing facing away from the second housing, and is electrically connected to the power distribution output component.

18. The vehicle according to claim 17, wherein
the controller further comprises a safety component (6), the safety component comprising a main body (61), a first connecting portion (62), and a second connecting portion (63), the first connecting portion and the second connecting portion being respectively arranged on opposite sides of the main body, the first connecting portion having a first connecting hole (621), and the second connecting portion having a second connecting hole (631); and
the power input component is inserted through the first connecting hole, and the power distribution output component is inserted through the second connecting hole.

19. The vehicle according to claim 17, wherein
the controller further comprises a power interface component (7) connected the power distribution output component and the circuit board.

20. The vehicle according to claim 19, wherein
the first housing has a through slot (13);
the power interface component comprises a first connecting component (71) and a second connecting component (72) which are connected to each other;
the first connecting component comprises a main body plate (711) and a connecting plate (712); one end of the connecting plate is connected to the main body plate, the other end of the connecting plate extends in a direction away from the main body plate, a side of the connecting plate away from the main body plate has a slot (713), the connecting plate extends from the through slot into a mounting hole, and the main body plate is connected to the power distribution output component; and
one end of the second connecting component extends into the slot, and the other end of the second connecting component is connected to the circuit board.
